(19) Europäisches Patentamt / European Patent Office / Office européen des brevets

(11) **EP 2 890 012 A1**

(12) **EUROPEAN PATENT APPLICATION**

(43) Date of publication:
01.07.2015 Bulletin 2015/27

(51) Int Cl.:
*H03L 7/099* (2006.01)   *H03C 3/09* (2006.01)

(21) Application number: 14275085.0

(22) Date of filing: 17.04.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 27.12.2013 KR 20130165714

(71) Applicant: Samsung Electro-Mechanics Co., Ltd.
Gyeonggi-do (KR)

(72) Inventors:
• Lee, Jae Hyung
  Gyeonggi-Do (KR)
• Kim, Myeung Su
  Gyeonggi-Do (KR)
• Cho, Koon Shik
  Gyeonggi-Do (KR)

(74) Representative: Potter Clarkson LLP
The Belgrave Centre
Talbot Street
Nottingham, NG1 5GG (GB)

(54) **Voltage regulating device, method for regulating voltage, and frequency synthesizer using the same**

(57) A voltage regulating device may provide a control voltage for modulation of a voltage-controlled oscillator. The voltage regulating device may include: a resistor array unit including a plurality of equivalent resistors connected to one another in series; a counter unit counting a first oscillation signal output from the voltage-controlled oscillator by a fixed clock; and a resistance allotment unit determining at least a portion of the plurality of equivalent resistors to be used for generating the control voltage using an output from the counter unit and trimming therewith.

160

FIG. 3

EP 2 890 012 A1

**Description**

**CROSS-REFERENCE TO RELATED APPLICATION**

This application claims the benefit of Korean Patent Application No. 10-2013-0165714 filed on December 27, 2013, with the Korean Intellectual Property Office, the disclosure of which is incorporated herein by reference.

**BACKGROUND**

The present disclosure relates to a voltage regulating device, a method for regulating a voltage, and a frequency synthesizer using the same.

In the field of wireless communications, a frequency synthesizer is widely used for generating a stable frequency for transmission/reception.

A commonly used frequency synthesizer is a phase-locked loop (PLL) including a voltage-controlled oscillator.

A PLL may modulate an output frequency of a voltage controlled oscillator using feedback control so as to fix the frequency as desired. Such a voltage controlled oscillator may receive a voltage signal as an input signal so as to adjust the oscillation frequency.

Therefore, it is necessary to adjust modulation of a voltage signal input to such a voltage controlled oscillator. To this end, an array of resistors is commonly employed.

Specifically, in such an array of resistors, predetermined equivalent resistors are connected to one another in series, and the array of resistors is used depending on a required voltage. In using such an array of resistors to output a required voltage, however, voltage values of the resistors of the array have to be measured experimentally one by one, by sequential searching, for example.

In particular, since the array of resistors may have fabrication errors, such experimental measurement of resistance values is essentially performed. As a result, it takes much time in frequency synthesizing or voltage controlled oscillation.

Patent Document 1 below relates to VCO capacitor bank trimming and calibrating but also has the same problem.

[Related Art Document]

(Patent Document 1) Korean Patent Laid-Open Publication No. 2011-0005730

**SUMMARY**

An aspect of the present disclosure may provide a voltage regulating device, a method for regulating a voltage, and a frequency synthesizer using the same, in which frequency displacement is determined for respective resistors within an array of resistors and a resistor corresponding to a required modulation width is directly determined, such that a voltage controlled oscillation operation may be performed more quickly and more accurately.

According to an aspect of the present disclosure, a voltage regulating device, providing a control voltage for modulation of a voltage-controlled oscillator, may include: a resistor array unit including a plurality of equivalent resistors connected to one another in series; a counter unit counting a first oscillation signal output from the voltage-controlled oscillator by a fixed clock; and a resistance allotment unit determining at least a portion of the plurality of equivalent resistors to be used for generating the control voltage using an output from the counter unit and trimming therewith.

The counter unit may receive the first oscillation signal and the fixed clock and may check a frequency by counting the first oscillation signal by the fixed clock.

The voltage regulating device may further include: a frequency dividing unit dividing a frequency of the first oscillation signal so that it has a frequency corresponding to a voltage difference caused by the equivalent resistors.

The resistance allotment unit may control switching of the resistor array unit so that the control voltage is generated using the determined at least a portion of the plurality of equivalent resistors.

The resistance allotment unit may set the determined at least a portion of the plurality of equivalent resistors to a target resistance value and store it.

The resistor allotment unit, if there is an error in a second oscillation signal output from the voltage controlled oscillator by applying the target resistance value, may re-determine at least a portion of the plurality of equivalent resistors in inverse ratio to the error and may trim therewith.

According to another aspect of the present disclosure, a frequency synthesizer may include: a phase-locked loop detecting a phase difference between a frequency of a frequency-divided oscillation signal and a frequency of a reference signal, and adjusting frequency dividing of the oscillation signal so that the phase difference lies within a calibration gain level; a phase comparator receiving the frequency-divided oscillation signal and the reference signal, and outputting the phase difference between the frequency of the oscillation signal and the frequency of the reference signal; a voltage controlled oscillator receiving a first control voltage corresponding to the phase difference and a second control voltage for modulation, and generating the oscillation signal by adjusting frequency dividing in response to the first and second control voltages; and a voltage regulator generating the second control voltage using at least a portion of a plurality of equivalent resistors connected to one another in series, and determining the at least a portion of the plurality of equivalent resistors such that a variation width of the oscillation signal corresponds to the equivalent resistors.

The frequency synthesizer may further include: a charge pump charging or discharging a capacitor according to the phase difference output from the phase comparator; and a filter generating a control voltage signal using a current output from the charge pump.

The voltage regulator may include: a resistor array unit including a plurality of equivalent resistors connected to one another in series; a counter unit counting a first oscillation signal output from the voltage-controlled oscillator by a fixed clock; and a resistance allotment unit determining at least a portion of the plurality of equivalent resistors to be used for generating the control voltage using an output from the counter unit and trimming therewith.

The counter unit may receive the first oscillation signal and the fixed clock and may check a frequency by counting the first oscillation signal by the fixed clock.

The voltage regulator may further include: a frequency dividing unit dividing a frequency of the first oscillation signal so that it has a frequency corresponding to a voltage difference caused by the equivalent resistors.

The resistance allotment unit may control switching of the resistor array unit so that the control voltage is generated using the determined at least a portion of the plurality of equivalent resistors.

The resistance allotment unit may set the determined at least a portion of the plurality of equivalent resistors to a target resistance value and store it.

The resistance allotment unit, if there is an error in a second oscillation signal output from the voltage controlled oscillator by applying the target resistance value, may re-determine at least a portion of the plurality of equivalent resistors in inverse ratio to the error and may trim therewith.

According to another aspect of the present disclosure, a method for regulating a voltage, performed in a voltage regulating device that provides a control voltage to a voltage controlled oscillator using a plurality of equivalent resistors connected to one another in series, may include: determining a frequency corresponding to a voltage difference cause by the equivalent resistors; calculating a target trim value by applying the checked frequency to a variation width of the voltage controlled oscillator; and performing post-correction, if there is a difference between an oscillation signal from the voltage controlled oscillator according to the target trim value and the target trim value.

The determining of the frequency may include: dividing a frequency of an oscillation signal output from the voltage controlled oscillator so that it has a frequency corresponding to the voltage difference caused by the equivalent resistors; and counting the frequency-divided oscillation signal by a fixed clock.

The calculating of the target trim value may include determining a value corresponding to the number of counts as the target trim value.

The performing of the post-correction may include: determining a difference between an oscillation signal output from the voltage controlled oscillator and a target signal for the target trim value by applying the target trim value; and increasing or decreasing a next trim value in inverse ratio to the checked difference.

## BRIEF DESCRIPTION OF DRAWINGS

The above and other aspects, features and other advantages of the present disclosure will be more clearly understood from the following detailed description taken in conjunction with the accompanying drawings, in which:

FIG. 1 is a block diagram of a frequency synthesizer according to an exemplary embodiment of the present disclosure;
FIG. 2 is a diagram for illustrating a typical trimming scheme using an array of resistors;
FIG. 3 is a block diagram of a voltage regulating device according to an exemplary embodiment of the present disclosure;
FIG. 4 is a block diagram of a voltage regulating device according to another exemplary embodiment of the present disclosure;
FIG. 5 is a diagram for illustrating trimming using an array of resistors according to an exemplary embodiment of the present disclosure; and
FIG. 6 is a flowchart for illustrating a method for regulating voltage according to an exemplary embodiment of the present disclosure.

## DETAILED DESCRIPTION

Exemplary embodiments of the present disclosure will now be described in detail with reference to the accompanying drawings.

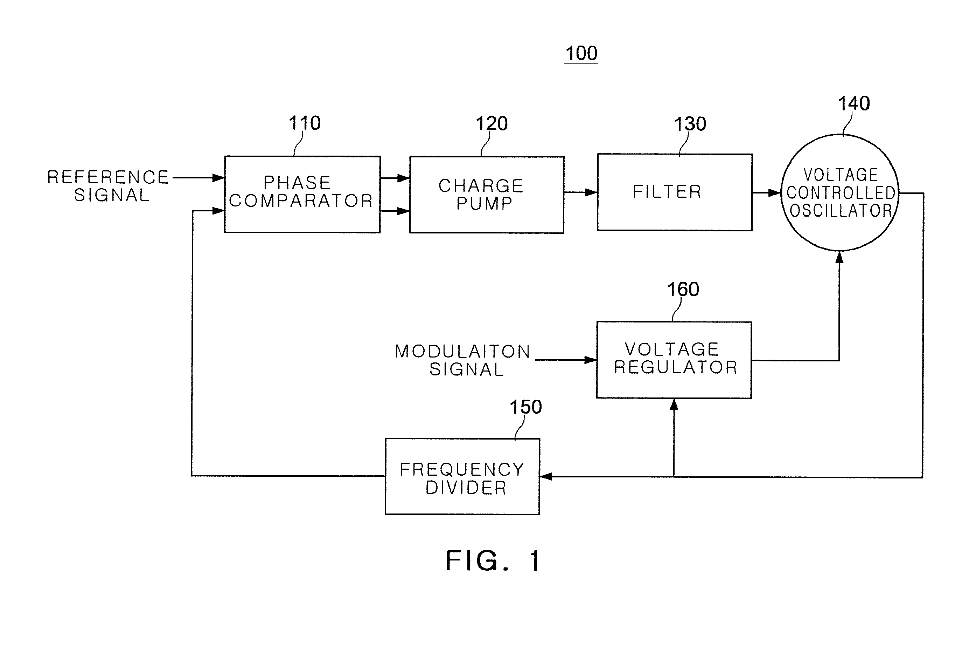

FIG. 1 is a block diagram of a frequency synthesizer according to an exemplary embodiment of the present disclosure.

Referring to FIG. 1, the frequency synthesizer 100 may include a phase comparator 110, a charge pump 120, a filter 130, a voltage-controlled oscillator 140, a frequency divider 150, and a voltage regulator 160.

The phase comparator 210, the charge pump 120, the filter 130, the voltage-controlled oscillator 140 and the frequency divider 150 may configure a phase-locked loop.

The phase comparator 110 may receive a reference signal and a frequency-divided signal and may compare frequencies of the two signals. The phase comparator 110 may provide an output signal corresponding to the phase difference between the reference signal and the frequency-divided signal to the charge pump 120.

The charge pump 120 may receive an output signal from the phase comparator 110 and may output a current corresponding thereto. The current output from the charge pump 120 may be input to the filter 130, and the filter 130 may convert the input current into a voltage so as to provide it to the voltage-controlled oscillator 140. Here, the voltage output from the filter 130 may be used as a first control voltage over the voltage-controlled oscillator 140.

The voltage-controlled oscillator 140 may receive a first control voltage corresponding to the phase difference output from the filter 130, and a second control voltage for modulation. The voltage-controlled oscillator 140 may adjust frequency-dividing in response to the first and second control voltages to generate an oscillation signal.

The frequency divider 150 may divide the frequency of the oscillation signal output from the voltage-controlled oscillator 140 at a predetermined ratio. For example, the frequency divider 150 may divide the frequency of the oscillation signal so that it has the same frequency with a reference signal, to generate a frequency-divided signal. Here, the above-described reference signal, oscillation signal and frequency-divided signal may be a voltage signal.

The voltage regulator 160 may generate a control voltage using at least a portion of a plurality of equivalent resistors connected to one another in series and may determine the at least a portion of the equivalent resistors such that a variation width of the oscillation signal corresponds to the equivalent resistors. That is, the voltage regulator 160 may determine a trim value of a resistor using the variation width of the oscillation signal. Further, the voltage regulator 160 may generate the control voltage using at least a portion of the plurality of equivalent resistors based on the determined trim value.

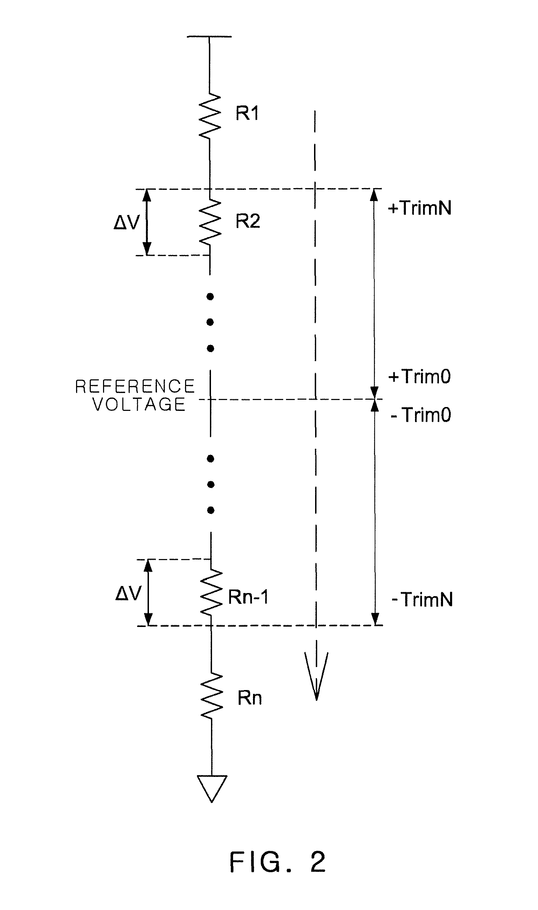

Hereinafter, the voltage regulator 160 will be described in more detail with reference to FIGS. 2 through 5. In some exemplary embodiments, the voltage regulator 160 may be implemented separately from the frequency synthesizer 100, i.e., may be implemented as a voltage regulating device. In the following descriptions, for convenience of illustration, the voltage regulator and the voltage regulating device will be commonly referred to as a voltage regulating device.

FIG. 2 illustrates a trimming scheme using an array of resistors according to the related art.

As shown, a voltage regulating device includes resistors connected in series. The resistors connected in series may have the equivalent resistance value.

The voltage regulating device shown in FIG. 2 employs a scheme in which sequentially connected resistors are used, i.e., a scheme in which trim values are sequentially increased. Here, each of the equivalent resistors has a constant voltage variation value $\Delta V$.

Accordingly, if a trim value is increased by one, a corresponding control voltage is increased by $\Delta V$. Owing to the increased control voltage, the output from the voltage-controlled oscillator is increased by $\Delta F$.

Therefore, in order to perform calibration according to the scheme shown in FIG. 2, operations of adjusting a trim value, determining an output from a voltage controlled oscillator by inputting the trim value, and re-adjusting the trim value have to be sequentially repeated. Consequently, it takes long time to perform calibration.

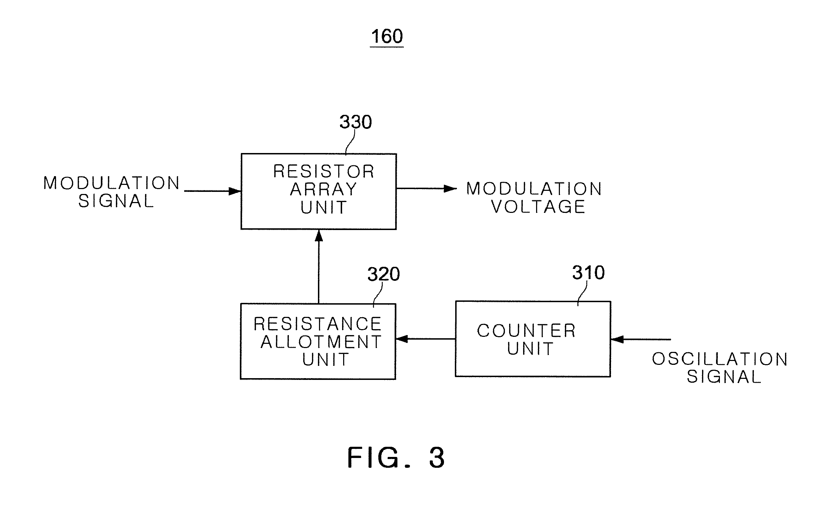

FIG. 3 is a block diagram of a voltage regulating device according to an exemplary embodiment of the present disclosure.

Referring to FIGS. 1 through 3, the voltage regulating device 160 may include a counter unit 310, a resistance allotment unit 320, and a resistor array unit 330.

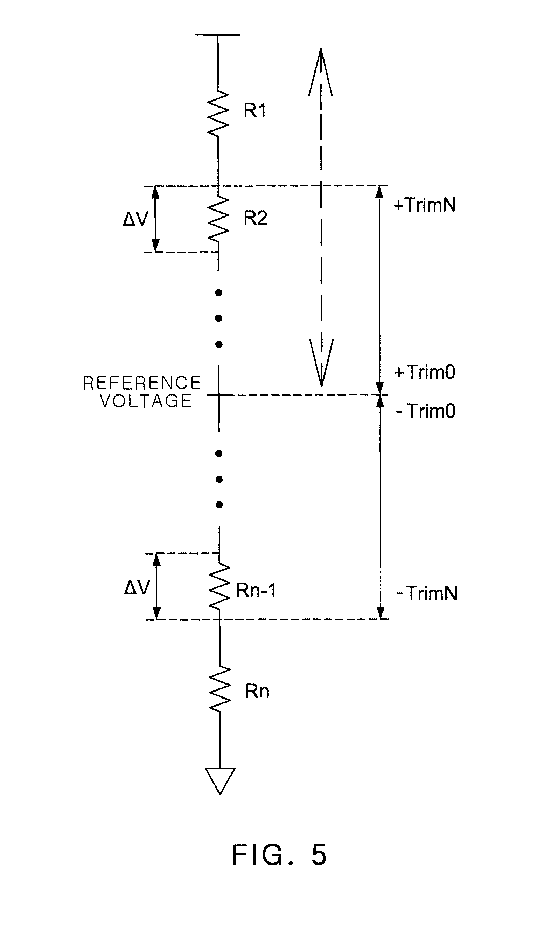

The resistor array unit 330 may include a plurality of equivalent resistors connected to one another in series. An example of the resistor array unit 330 is shown in FIG. 5.

The counter unit 310 may count an oscillation signal output from the voltage-controlled oscillator 140 by a fixed clock (A: reference clock). The counter unit 310 may receive the oscillation signal and the fixed clock and may count the oscillation signal by the fixed clock to check the frequency.

The resistance allotment unit 320 may determine a trim value necessary for generating a control voltage using an output from the counter unit 310. That is, the resistance allotment unit 320 may determine at least a portion of the plurality of equivalent resistors necessary for generating the control voltage so as to trim therewith. Here, the control voltage is for modulation input to the voltage-controlled oscillator 140.

In exemplary embodiment, the resistance allotment unit 320 may control switching of the resistor array unit so that at least a portion of the plurality of equivalent resistors in the resistor array unit 330 are used depending on the determined trim value. That is, the resistance allotment unit 320 may control a switch (not shown) of the resistor array unit 330 so that resistors corresponding up to the trim value, among the plurality of equivalent resistors connected to one another in series, are used.

In an exemplary embodiment, the resistance allotment unit 320 may set the determined trim value to a target trim value. That is, the resistance allotment unit 320 may set at least a portion of the plurality of equivalent resistors to the target resistance value and store it. Here, the set target trim value is an ideal value in which no fabrication error is reflected. Since no fabrication error in the resistor array unit 330 is reflected, there may be an error between the target trim value and the actually measured trim value, depending on the characteristics of the resistor array unit 330.

Accordingly, the resistance allotment unit 320 may use the target trim value at the first searching and then may correct a difference between actually measured value C and the target trim value G (post-correction) by applying the target trim value.

In an exemplary embodiment, if there is an error in a second oscillation signal output from the voltage controlled oscillator by applying the target resistance value G, i.e., actually measured value C, the resistance allotment unit 320 may re-determine at least a portion of the plurality of equivalent resistors in inverse ratio to the error and may trim therewith.

For example, if the actually measured value C is twice the target trim value G or more, the resistance allotment unit 320 may vary the next trim value by (C - G) / 2.

Alternatively, if the actually measured value C is between the half of and twice the target trim value G, the resistance allotment unit 320 may vary the next trim value sequentially or stepwise within the range.

Alternatively, if the actually measured value C is less than the half of the target trim value G, the resistance allotment unit 320 may vary the next trim value by 2*(G-C).

More specifically, 0 or 1 may be input as the modulation signal, and if 1 is input, it represents a modulation frequency in the positive (+) direction with respect to the reference voltage. Accordingly, a voltage is varied by the target trim value in the positive direction in the array of resistor. If 0 is input, it represents a modulation frequency in the negative (-) direction with respect to the reference voltage, and thus the voltage is varied by the target trim value in the negative direction in the array of resistor.

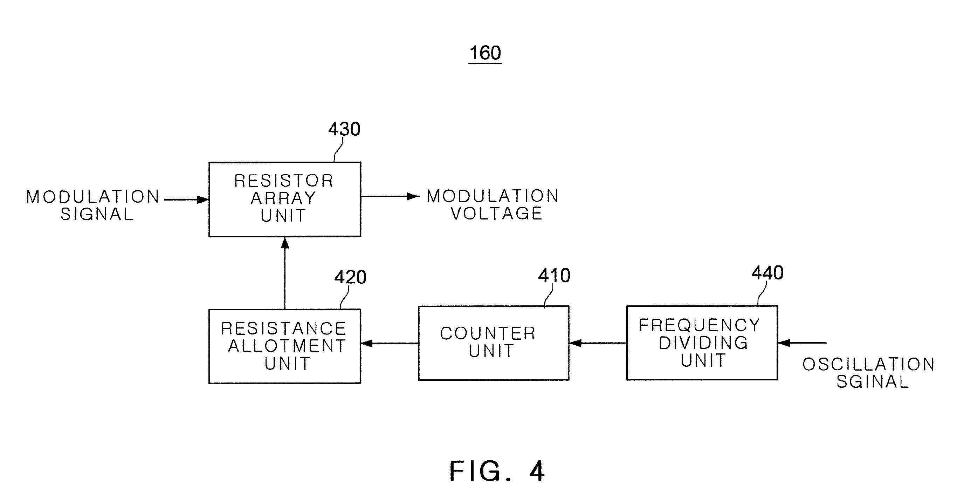

FIG. 4 is a block diagram of a voltage regulating device according to another exemplary embodiment of the present disclosure.

The voltage regulating device 160 according to the exemplary embodiment shown in FIG. 4 may further include a frequency dividing unit 440.

The frequency dividing unit 440 may divide the frequency of the oscillation signal output from the voltage-controlled oscillator 140 to provide it to the counter unit 410. The frequency dividing unit 440 may divide the frequency of the oscillation signal so that it has the frequency corresponding to the voltage difference caused by the equivalent resistors.

More specifically, the variation value of the frequency $\Delta F$ of the voltage-controlled oscillator 140 may be divided by the frequency divider 150 (e.g., $\Delta F / 64$). Therefore, in order to count the divided $\Delta F / 64$ by a fixed clock to check it, frequency dividing may be performed by the frequency dividing unit 440 until the number of counts by the fixed clock exhibits a minimum difference of 1.

This amount of frequency dividing may be expressed by the following Mathematical Expression 1:

$$[\text{Mathematical Expression 1}]$$

$$\text{Amount of Frequency Dividing} = Tc / (T2 - T1)$$

Where Tc denotes a period of a fixed clock frequency of a counter, and T1 denotes a period of an output frequency of the frequency divider 150 at trim n. T2 denotes a period of an output frequency of the frequency divider 150 at trim n+1.

When it is applied to a binary frequency divider, Mathematical Equation 2 is obtained:

$$[\text{Mathematical Expression 2}]$$

$$2^{n-1} < Tc / (T2 - T1) < 2^{n}$$

Where $2^{n}$ denotes the amount of frequency dividing of the binary frequency divider.

Consequently, the difference of 1 in a fixed clock count in the counter unit 410 corresponds to the difference of 1 in trim, and this may correspond to the variation width of frequency $\Delta F$ of the voltage controlled oscillator 140.

Accordingly, once a desired modulation width F of the voltage controlled oscillator 140 is determined by using this relationship, a difference D in the fixed clock count values corresponding to the modulation width is also calculated. This may be represented by Mathematical Equation 3.

$$[\text{Mathematical Expression 3}]$$

$$F = N(trim) * \Delta F = D * \Delta F$$

As a result, according to the exemplary embodiment, the difference value D corresponding to a desired modulation width is set to be a target trim value G, and a trim value corresponding thereto may be measured by applying it to the first searching. This exhibits excellent efficiency since it can be started with the closest position to a target value, compared to a sequential manner or a method starting with a median value. Then, an actually measured value of the resistance allotment unit, including a fabrication error, is compared with the target value to repeat varying trims, thereby obtaining an accurate trim value.

FIG. 5 is a diagram for illustrating trimming using an array of resistors according to an exemplary embodiment of the present disclosure.

In the shown example, if the calculated target trim value G corresponds to R2, the control signal is generated with respect to R2 initially. For the control signal thus generated, if a variation width of a frequency of the voltage-controlled oscillator 140 exists, the above-mentioned post-deviation-correction may be performed with respect to R2.

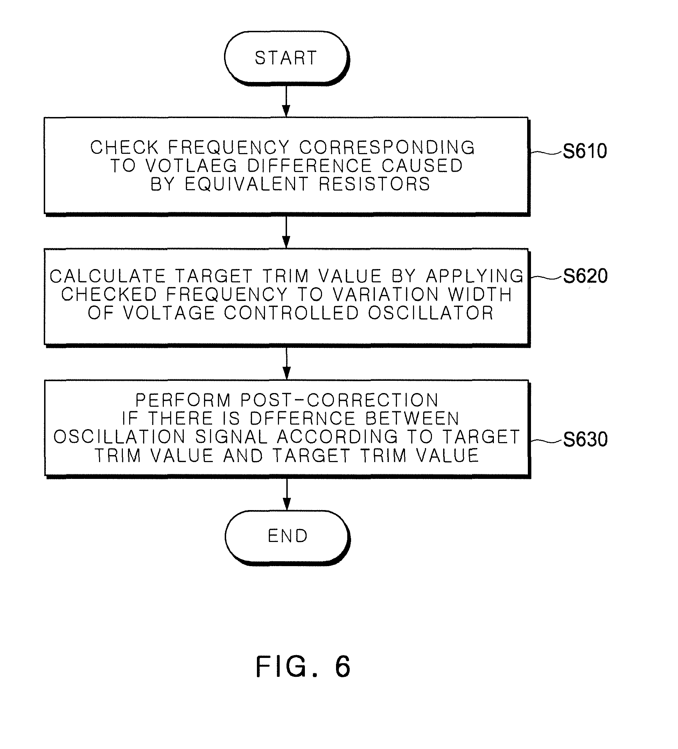

FIG. 6 is a flowchart for illustrating a method for regulating voltage according to an exemplary embodiment of the present disclosure.

The method illustrated in FIG. 6 will be described with respect to the voltage regulating device described above with reference to FIGS. 3 through 5, and, therefore, redundant descriptions on the same elements as those described above will not be made.

Referring to FIG. 6, the voltage regulating device 160 may check a frequency corresponding to a voltage difference caused by the equivalent resistors (S610). That is, the relation between the trim value and the variation width of a frequency of the voltage-controlled oscillator may be checked.

Then, the voltage regulating device 160 may calculate the target trim value by applying the checked frequency to the variation width of the voltage-controlled oscillator (S620).

If there is a difference between the oscillation signal from the voltage-controlled oscillator according to the target trim value and the target trim value, the voltage regulating device 160 may perform post-correction (S630).

In an example of operation S610, the voltage regulating device 160 may divide the frequency of the oscillation signal output from the voltage-controlled oscillator so that it has the frequency corresponding to the voltage difference caused by the equivalent resistors. Then, the voltage regulating device 160 may count the frequency-divided oscillation signal by a fixed clock.

In an example of operation S620, the voltage regulating device 160 may determine a value corresponding to the number of counts as the trim value.

In an example of operation S630, the voltage regulating device 160 may check a difference between the oscillation signal output from the voltage-controlled oscillator by applying the target trim value and a target signal for the target trim value, and may increase or decrease the next trim value in inverse ratio to the checked difference.

As set forth above, according to exemplary embodiments of the present disclosure, frequency displacement is determined for respective resistors within an array of resistors and a resistor corresponding to a required modulation width is directly determined, such that a voltage controlled oscillation operation can be performed more quickly and more accurately.

While exemplary embodiments have been shown and described above, it will be apparent to those skilled in the art that modifications and variations could be made without departing from the spirit and scope of the present disclosure as defined by the appended claims.

## Claims

1.    A voltage regulating device for providing a control voltage for modulation of a voltage-controlled oscillator, the voltage regulating device comprising:

    a resistor array unit including a plurality of equivalent resistors connected to one another in series;
    a counter unit counting a first oscillation signal output from the voltage-controlled oscillator by a fixed clock; and

a resistance allotment unit determining at least a portion of the plurality of equivalent resistors to be used for generating the control voltage using an output from the counter unit and trimming therewith.

2. The voltage regulating device of claim 1, wherein the counter unit receives the first oscillation signal and the fixed clock and checks a frequency by counting the first oscillation signal by the fixed clock.

3. The voltage regulating device of claim 1, further comprising a frequency dividing unit dividing a frequency of the first oscillation signal so that it has a frequency corresponding to a voltage difference caused by the equivalent resistors.

4. The voltage regulating device of claim 1, wherein the resistance allotment unit controls switching of the resistor array unit so that the control voltage is generated using the determined at least a portion of the plurality of equivalent resistors.

5. The voltage regulating device of claim 1, wherein the resistance allotment unit sets the determined at least a portion of the plurality of equivalent resistors to a target resistance value and stores it.

6. The voltage regulating device of claim 1, wherein the resistance allotment unit, if there is an error in a second oscillation signal output from the voltage controlled oscillator by applying the target resistance value, re-determines at least a portion of the plurality of equivalent resistors in inverse ratio to the error and trims therewith.

7. A frequency synthesizer, comprising:

a phase-locked loop detecting a phase difference between a frequency of a frequency-divided oscillation signal and a frequency of a reference signal, and adjusting frequency dividing of the oscillation signal so that the phase difference lies within a calibration gain level;
a phase comparator receiving the frequency-divided oscillation signal and the reference signal, and outputting the phase difference between the frequency of the oscillation signal and the frequency of the reference signal;
a voltage controlled oscillator receiving a first control voltage corresponding to the phase difference and a second control voltage for modulation, and generating the oscillation signal by adjusting frequency dividing in response to the first and second control voltages; and
a voltage regulator generating the second control voltage using at least a portion of a plurality of equivalent resistors connected to one another in series, and determining the at least a portion of the plurality of resistors such that a variation width of the oscillation signal corresponds to the equivalent resistors.

8. The frequency synthesizer of claim 7, further comprising:

a charge pump charging or discharging a capacitor according to the phase difference output from the phase comparator; and
a filter generating a control voltage signal using a current output from the charge pump.

9. The frequency synthesizer of claim 7, wherein the voltage regulator includes:

a resistor array unit including a plurality of equivalent resistors connected to one another in series;
a counter unit counting a first oscillation signal output from the voltage-controlled oscillator by a fixed clock; and
a resistance allotment unit determining at least a portion of the plurality of equivalent resistors to be used for generating the control voltage using an output from the counter unit and trimming therewith.

10. The frequency synthesizer of claim 9, wherein the counter unit receives the first oscillation signal and the fixed clock and checks a frequency by counting the first oscillation signal by the fixed clock.

11. The frequency synthesizer of claim 8, wherein the voltage regulator further includes a frequency dividing unit dividing a frequency of the first oscillation signal so that it has a frequency corresponding to a voltage difference caused by the equivalent resistors.

12. The frequency synthesizer of claim 8, wherein the resistance allotment unit controls switching of the resistor array unit so that the control voltage is generated using the determined at least a portion of the plurality of equivalent resistors.

13. The frequency synthesizer of claim 8, wherein the resistance allotment unit sets the determined at least a portion of the plurality of equivalent resistors to a target resistance value and stores it.

14. The frequency synthesizer of claim 13, wherein the resistance allotment unit, if there is an error in a second oscillation signal output from the voltage controlled oscillator by applying the target resistance value, re-determines at least a portion of the plurality of equivalent resistors in inverse ratio to the error and trims therewith.

15. A method for regulating a voltage, performed in a voltage regulating device that provides a control voltage to a voltage controlled oscillator using a plurality of equivalent resistors connected to one another in series, the method comprising:

determining a frequency corresponding to a voltage difference cause by the equivalent resistors;
calculating a target trim value by applying the checked frequency to a variation width of the voltage controlled oscillator; and
performing post-correction, if there is a difference between an oscillation signal from the voltage controlled oscillator according to the target trim value and the target trim value.

16. The method of claim 15, wherein the determining of the frequency includes:

dividing a frequency of an oscillation signal output from the voltage controlled oscillator so that it has a frequency corresponding to the voltage difference caused by the equivalent resistors; and
counting the frequency-divided oscillation signal by a fixed clock.

17. The method of claim 16, wherein the calculating of the target trim value includes determining a value corresponding to the number of counts as the target trim value.

18. The method of claim 15, wherein the performing of the post-correction includes:

determining a difference between an oscillation signal output from the voltage controlled oscillator and a target signal for the target trim value by applying the target trim value; and
increasing or decreasing a next trim value in inverse ratio to the checked difference.

EP 2 890 012 A1

FIG. 1

FIG. 2

FIG. 3

EP 2 890 012 A1

FIG. 4

EP 2 890 012 A1

FIG. 5

START

CHECK FREQUENCY CORRESPONDING
TO VOTLAEG DIFFERENCE CAUSED
BY EQUIVALENT RESISTORS ⎯S610

CALCULATE TARGET TRIM VALUE BY APPLYING
CHECKED FREQUENCY TO VARIATION WIDTH
OF VOLTAGE CONTROLLED OSCILLATOR ⎯S620

PERFORM POST-CORRECTION
IF THERE IS DFFERNCE BETWEEN
OSCILLATION SIGNAL ACCORDING TO TARGET
TRIM VALUE AND TARGET TRIM VALUE ⎯S630

END

FIG. 6

Europäisches
Patentamt

European
Patent Office

Office européen
des brevets

# EUROPEAN SEARCH REPORT

Application Number

EP 14 27 5085

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 350 949 A (NEC CORP [JP] NEC CORP [JP]; NEC ELECTRONICS CORP [JP]) 13 December 2000 (2000-12-13) | 1-6, 15-18 | INV. H03L7/099 H03C3/09 |
| Y | * page 5, line 19 - page 15, line 2; figures 2,4 * | 7-14 | |
| Y | US 2012/212296 A1 (CHEN HSIN-HUNG [TW] ET AL) 23 August 2012 (2012-08-23) * paragraph [0015] - paragraph [0018]; figure 1 * | 7-14 | |

TECHNICAL FIELDS
SEARCHED       (IPC)

H03L
H03C

The present search report has been drawn up for all claims

| Place of search | Date of completion of the search | Examiner |
|---|---|---|
| The Hague | 21 May 2015 | Beasley-Suffolk, D |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**  EP 14 27 5085

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2015

| Patent document cited in search report | | Publication date | Patent family member(s) | | Publication date |
|---|---|---|---|---|---|
| GB 2350949 | A | 13-12-2000 | GB | 2350949 A | 13-12-2000 |
| | | | JP | 2000341119 A | 08-12-2000 |
| | | | US | 6329860 B1 | 11-12-2001 |
| US 2012212296 | A1 | 23-08-2012 | CN | 102647186 A | 22-08-2012 |
| | | | TW | 201236421 A | 01-09-2012 |
| | | | US | 2012212296 A1 | 23-08-2012 |

EPO FORM P0459

For more details about this annex : see Official Journal of the European Patent Office, No. 12/82

**EP 2 890 012 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020130165714

- KR 20110005730